# EUROPEAN PATENT APPLICATION

(11) **EP 4 102 072 A2**
(43) Date of publication of application: **14.12.2022**
(21) Application number: 22170216.0
(22) Date of filing: 27.04.2022
(51) Int. Cl.: F04B 43/04

(54) **MICRO-ELECTROMECHANICAL SYSTEM PUMP**

(30) Priority: 11.06.2021 TW 110121457
(71) Applicant: Microjet Technology Co., Ltd., Hsinchu (TW)
(72) Inventor: Mou, Hao-Jan, Hsinchu (TW); Han, Yung-Lung, Hsinchu (TW); Huang, Chi-Feng, Hsinchu (TW); Kuo, Chun-Yi, Hsinchu (TW); Lin, Tsung-I, Hsinchu (TW)
(74) Representative: Uexküll & Stolberg

(57) **Abstract**

A MEMS pump (100) includes a first substrate (1), a first oxide layer (3), a second substrate (2), a second oxide layer (5), a third substrate (4) and a piezoelectric element (6) sequentially stacked to form a modular structure. The first substrate (1) has an inlet aperture (11). The first oxide layer (3) has at least one fluid inlet channel (31) and a convergence chamber (32). One end of the fluid inlet channel (31) is in communication with the convergence chamber (32) and the other end of the fluid inlet channel (31) is in communication with the inlet aperture (11). The second substrate (2) has a through hole (21) misaligned with the inlet aperture (11) and in communication with the convergence chamber (32). The second oxide layer (5) has a gas chamber (51) with a concave central portion. The third substrate (4) has a plurality of gas flow channels (41) misaligned with the through hole (21). The modular structure has a length (L), a width (W) and a height (H).

## Description

### FIELD OF THE INVENTION

The present disclosure relates to a micro-electromechanical system (MEMS) pump, and more particularly to a MEMS pump manufactured by a semiconductor process.

### BACKGROUND OF THE INVENTION

Currently, the products used in many fields such as pharmaceutical industries, computer techniques, printing industries or energy industries are developed toward elaboration and miniaturization. The fluid transportation device is the curial and important components used in, for example, micro pumps, atomizers, print heads or the industrial printers. Therefore, how to take advantage of an innovative structure to break through the bottleneck in the relevant prior art has become an important issue of development.

With the rapid advancement of science and technology, the application of fluid transportation device tends to be more and more diversified. For example, gas transportation devices are gradually popular in industrial applications, biomedical applications, medical care applications, electronic cooling applications and so on, or even the wearable devices. It is obviously that the conventional fluid transportation devices gradually tend to miniaturize the structure and maximize the flow rate thereof. Therefore, the process hierarchy of MEMS pump attracted more and more attention gradually.

### SUMMARY OF THE INVENTION

An object of the present disclosure is to provide a MEMS pump manufactured by a semiconductor process for reducing the restriction stem from the volume of the MEMS pump.

In accordance with an aspect of the present disclosure, a MEMS pump is provided. The MEMS pump includes a first substrate, a first oxide layer, a second substrate, a second oxide layer, a third substrate and a piezoelectric element. The first substrate has a first thickness and at least one inlet aperture. The first substrate is manufactured by a thinning process of a semiconductor process. The at least one inlet aperture is formed by a lithography and etching process. The first oxide layer has at least one fluid inlet channel and a convergence chamber. The first oxide layer is formed and stacked upon the first substrate by the semiconductor process. The at least one fluid inlet channel and the convergence chamber are formed by the lithography and etching process, wherein one end of at least one fluid inlet channel is in communication with the convergence chamber, and the other end of the at least one fluid inlet channel is in communication with the at least one inlet aperture. The second substrate has a second thickness and a through hole. The second substrate is manufactured by the thinning process of the semiconductor process and placed upon the first oxide layer. The through hole is formed by the lithography and etching process, and the through hole is misaligned with the inlet apertures of the first substrate and in communication with the convergence chamber of the first oxide layer. The second oxide layer is formed by a sputtering process and stacked on the second substrate. The second oxide layer has a gas chamber with a concave central portion formed by the lithography and etching process. The third substrate has a third thickness and a plurality of gas flow channels. The third substrate is manufactured by the thinning process of the semiconductor process and stacked on the second oxide layer. The plurality of gas flow channels are formed by the lithography and etching process and are misaligned with the through hole of the second substrate. The gas chamber of the second oxide layer is in communication with the through hole of the second substrate and the plurality of gas flow channels of the third substrate. The piezoelectric element is formed and stacked on the third substrate by the semiconductor process. The first substrate, the first oxide layer, the second substrate, the second oxide layer, the third substrate and the piezoelectric element are fabricated into a modular structure, and the modular structure has a length, a width and a height.

In accordance with another aspect of the present disclosure, a MEMS pump is provided. The MEMS pump includes a first substrate, a first oxide layer, a second substrate, a second oxide layer, a third substrate and a piezoelectric element. The first substrate has a first thickness and at least one inlet aperture. The first substrate is manufactured by a thinning process of a semiconductor process. The at least one inlet aperture is formed by a lithography and etching process. The first oxide layer has at least one fluid inlet channel and a convergence chamber. The first oxide layer is formed and stacked upon the first substrate by the semiconductor process. The at least one fluid inlet channel and the convergence chamber are formed by the lithography and etching process, wherein one end of at least one fluid inlet channel is in communication with the convergence chamber, and the other end of the at least one fluid inlet channel is in communication with the at least one inlet aperture. The second substrate has a second thickness and a through hole. The second substrate is manufactured by the thinning process of the semiconductor process and placed upon the first oxide layer. The through hole is formed by the lithography and etching process, and the through hole is misaligned with the inlet apertures of the first substrate and in communication with the convergence chamber of the first oxide layer. The second oxide layer is formed by a sputtering process and stacked on the second substrate. The second oxide layer has a gas chamber with a concave central portion formed by the lithography and etching process. The third substrate has a third thickness and a plurality of gas flow channels. The third substrate is manufactured by the thinning process of the semiconductor process and stacked on the second oxide layer. The plurality of gas flow channels are formed by the lithography and etching process, and are misaligned with the through hole of the second substrate. The gas chamber of the second oxide layer is in communication with the through hole of the second substrate and the plurality of gas flow channels of the third substrate. The piezoelectric element is formed and stacked on the third substrate by the semiconductor process. The first substrate, the first oxide layer, the second substrate, the second oxide layer, the third substrate and the piezoelectric element are fabricated into a modular structure, and the modular structure has a length ranging from 1 nm to 999 nm, a width ranging from 1 nm to 999 nm and a height ranging from 1 nm to 999 nm.

### BRIEF DESCRIPTION OF THE DRAWINGS

The above contents of the present disclosure will become more readily apparent to those ordinarily skilled in the art after reviewing the following detailed description and accompanying drawings, in which:
FIG. 1 is a cross-sectional view illustrating a MEMS pump according an embodiment of the present disclosure;
FIGS. 2A to 2C are cross-sectional views illustrating the operation steps of the MEMS pump according to the embodiment of the present disclosure; and
FIG. 3 is a top view illustrating a third substrate of the MEMS pump shown in FIG. 1.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

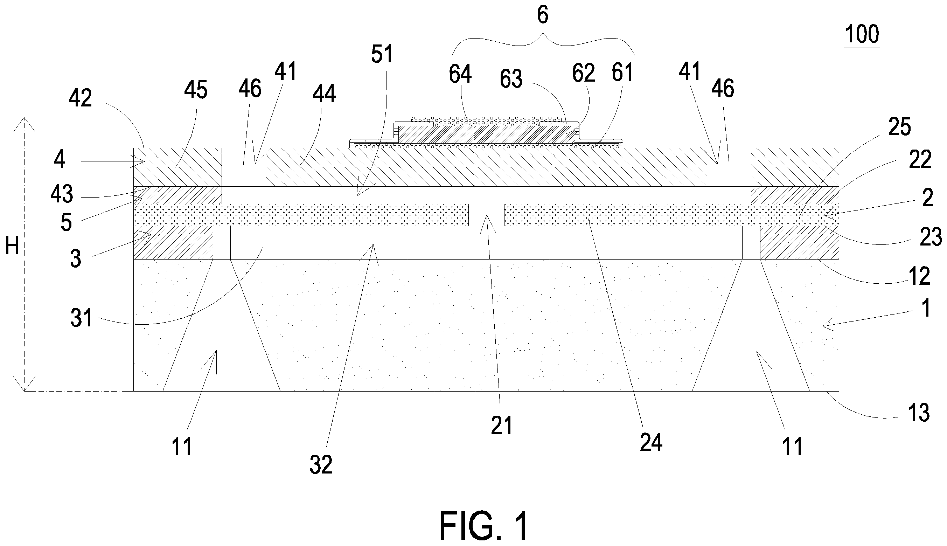

FIG. 1 is a cross-sectional view illustrating a MEMS pump according an embodiment of the present disclosure. The present discourse provides a MEMS pump 100, which can widely apply in many fields such as medical biotechnology industries, energy industries, computer techniques or printing industries for guiding fluid and increasing or controlling the flow speed of fluid. Please refer to FIG. 1, the MEMS pump 100 of the present disclosure includes a first substrate 1, a second substrate 2, a first oxide layer 3, a third substrate 4, a second oxide layer 5 and a piezoelectric element 6 sequentially and integrally stacked to form the entire structure of the MEMS pump 100.

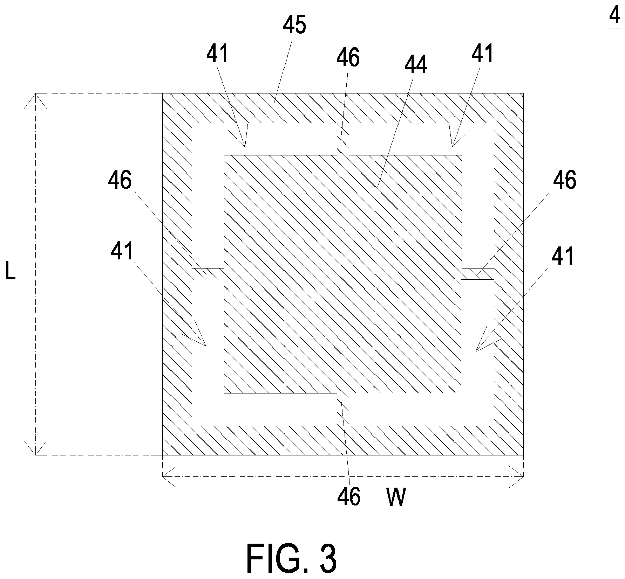

Please refer to FIG. 1 and FIG. 3. Notably, the first substrate 1, the first oxide layer 3, the second substrate 2, the second oxide layer 5, the third substrate 4 and the piezoelectric element 6 are fabricated into a modular structure, and the modular structure has a length L, a width W and a height H. In an embodiment, the modular structure has a volume formed with the length L ranging from 1 mm to 999 mm, the width W ranging from 1 mm to 999 mm and the height H ranging from 1 mm to 999 mm, but not limited thereto. In an embodiment, the modular structure has a volume formed with the length L ranging from 1 µm to 999 µm, the width W ranging from 1 µm to 999 µm and the height H ranging from 1 µm to 999 µm. Alternatively, in another embodiment, the modular structure has a volume formed with the length L ranging from 1 nm to 999 nm, the width W ranging from 1 nm to 999 nm and the height H ranging from 1 nm to 999 nm. In order to simplify the description, the manufacturing process below is not limited to nano-manufacturing process, micro-manufacturing process, and millimeter-manufacturing process. The manufacturing process of the present disclosure is adjustable and can be replaced by nano-manufacturing process, micro-manufacturing process, or millimeter-manufacturing process according to the practical requirement. Specifically, the description of the present invention is illustrated by micro-manufacturing process.

The first substrate 1, the second substrate 2 and the third substrate 4 described above may be made of the same material, but not limited thereto. In this embodiment, all of the three substrates above are silicon chips formed by a crystal growth process of the semiconductor process. The crystal growth process may be a poly silicon growth technique, such that the first substrate 1, the second substrate 2 and the third substrate 4 may be polysilicon chips. In addition, the first substrate 1 has a first thickness, the second substrate 2 has a second thickness, and the third substrate 4 has a third thickness, wherein the first thickness, the second thickness and the third thickness may be formed by a thinning process. In this embodiment, the first thickness of the first substrate 1 is larger than the third thickness of the third substrate 4, and the third thickness of the third substrate 4 is larger than the second thickness of the second substrate 2. The substrate thinning process may be achieved by grinding, etching, cutting or any other process to obtain the desired thickness of the substrate. Consequently, the first thickness ranging from 150 µm to 200 µm is obtained by the thinning process in the micro-manufacturing process, the second thickness ranging from 2 µm to 5 µm is obtained by the thinning process in the micro-manufacturing process, and the third thickness ranging from 10 µm to 20 µm is obtained by the thinning process in the micro-manufacturing process.

The first oxide layer 3 and the second oxide layer 5 may be both made of the same material, but not limited thereto. In this embodiment, the first oxide layer 3 and the second oxide layer 5 are silicon dioxide (SiO₂) films, which can be formed by a sputtering process or high temperature oxidation of the semiconductor procedure, so as to form the films with desired thickness. In this embodiment, the thickness of the first oxide layer 3 is greater than the thickness of the second oxide layer 5. Consequently, the first oxide layer 3 manufactured by the micro-manufacturing process has a thickness ranging from 10 µm to 20µm, and the second oxide layer 5 manufactured by the micro-manufacturing process has a thickness ranging from 0.5 µm to 2 µm.

The first substrate 1 formed by the crystal growth process of the semiconductor process has a first top surface 12, a first bottom surface 13 and at least one inlet aperture 11, and the at least one inlet aperture 11 is formed by a lithography and etching process. Each inlet aperture 11 penetrates the first substrate 1 from the first bottom surface 13 to the first top surface 12. In this embodiment, there are two inlet holes in the first substrate 1, but not limited thereto. Moreover, the inlet aperture 11 is cone-shaped and tapered from the first bottom surface 13 to the first top surface 12 to enhance the inhale efficiency.

The first oxide layer 3 described above is formed by the sputtering process or high temperature oxidation of the semiconductor procedure and is stacked upon the first top surface 12 of the first substrate 1. In addition, at least one fluid inlet channel 31 and a convergence chamber 32 are formed on the first oxide layer 3 by the lithography and etching process. The number and the position of the at least one fluid inlet channel 31 is corresponding to the inlet aperture 11. In this embodiment, the number of the fluid inlet channel 31 is illustrated by two, but not limited thereto. One end of each fluid inlet channel 31 is in communication with the corresponding inlet aperture 11, and the other end of the fluid inlet channel 31 is in communication with the convergence chamber 32. Consequently, the gas inhaled from the two inlet apertures 11 can be converged into the convergence chamber 32 through the corresponding fluid inlet channels 31, respectively.

The second substrate 2 formed by the crystal growth process of the semiconductor process has a second top surface 22, a second bottom surface 23, a resonance part 24 and a fixed part 25, and a through hole 21 is formed by the lithography and etching process. The through hole 21 located in the center of the second substrate 2 penetrates from the second top surface 22 to the second bottom surface 23. The resonance part 24 locates at the periphery region of the through hole 21, and the fixed part 25 locates at the periphery region of the resonance part 24. Moreover, the second bottom surface 23 of the second substrate 2 is disposed upon the first oxide layer 3. The through hole 21 of the second substrate 2 is perpendicularly aligned and in communication with the convergence chamber 32 of the first oxide layer 3, and the through hole 21 is misaligned with the inlet apertures 11 of the first substrate 1.

The second oxide layer 5 is formed upon the second top surface 22 of the second substrate 2 by the sputtering process or high temperature oxidation of the semiconductor process, and a central portion of the second oxide layer 5 is recessed to form a gas chamber 51 by the lithography and etching process. The gas chamber 51 is corresponding in position to the through hole 21 of the second substrate 2 and the resonance part 24 in the periphery region of the through hole 21. Consequently, the gas can flow into the gas chamber 51 by passing through the through hole 21, and the resonance part 24 can displace upward and downward in the gas chamber 51.

The third substrate 4 described above has a third top surface 42 and a third bottom surface 43 formed by the crystal growth process of a semiconductor process. Moreover, a plurality of gas flow channels 41 penetrated from the third top surface 42 to the third bottom surface 43 are formed by the lithography and etching process, so as to define a vibration part 44, a periphery part 45 and a plurality of connection parts 46 of the third substrate 4, as shown in FIG. 3. The vibration part 44 is surrounded by the gas flow channels 41. The periphery part 45 surrounds the periphery region of the gas flow channels 41. The plurality of the connection parts 46 are disposed between the gas flow channels 41, and connect to the vibration part 44 and the periphery part 45. In this embodiment, the number of the gas flow channels 41 and the number of the connection parts 46 are illustrated by four, respectively, but not limited thereto.

Please refer to FIG. 1 again. The piezoelectric element 6 includes a lower electrode layer 61, a piezoelectric layer 62, an insulation layer 63 and an upper electrode layer 64. The piezoelectric element 6 may be formed by physical vapor deposition (PVD) process, chemical vapor deposition (CVD) process or sol-gel process, but not limited thereto. In this embodiment, the lower electrode layer 61 and the upper electrode layer 64 are formed by film deposition such as PVD or CVD. The lower electrode layer 61 is disposed and stacked on the third top surface 42 of the third substrate 4, and is located on the vibration part 44 of the third substrate 4. The piezoelectric layer 62 may be formed by film deposition process or sol-gel process, and the piezoelectric layer 62 is stacked on the lower electrode layer 61, thereby the piezoelectric layer 62 and the lower electrode layer 61 can electrically connect to each other by the contact area thereof. Moreover, the area of the piezoelectric layer 62 is smaller than the area of the lower electrode layer 61, so that the lower electrode layer 61 cannot be completely covered by the piezoelectric layer 62. The insulation layer 63 is formed and covered on a part of the piezoelectric layer 62 and the uncovered area of the lower electrode layer 61, so as to cover on a partial surface of the piezoelectric layer 62 and a partial surface of the lower electrode 61. At last, the upper electrode layer 64 is formed on a part of the insulation layer 63 and the uncovered area of the piezoelectric layer 62, so as to stack on the insulation layer 63 and a remaining surface of the piezoelectric layer 62 without the insulation layer 63 disposed thereon. As a result, the upper electrode layer 64 is electrically connected with the piezoelectric layer 62 by the contact area thereof. At the same time, the insulation layer 63 is utilized to hinder the upper electrode layer 64 from directly contacting the lower electrode layer 61, thereby preventing the occurrence of electrical short circuits.

Please refer to FIG. 1. The first oxide layer 3 is disposed between the first top surface 12 of the first substrate 1 and the second bottom surface 23 of the second substrate 2. The second oxide layer 5 is disposed between the second top surface 22 of the second substrate 2 and the third bottom surface 43 of the third substrate 4. Moreover, the piezoelectric element 6 is disposed on the third top surface 42 of the third substrate 4 and is corresponding in position to the gas chamber 51 of the second oxide layer 5. The first oxide layer 3 is disposed between the first substrate 1 and the second substrate 2, the fluid inlet channels 31 therein are in communication with the inlet apertures 11 of the first substrate 1, and the convergence chamber 32 is in communication with the through hole 21 of the second substrate 2. Therefore, the gas is inhaled from the inlet apertures 11 of the first substrate 1, converged to the convergence chamber 32 through the fluid inlet channels 31, and then flows upwardly through the through hole 21. Furthermore, the second oxide layer 5 is disposed between the second substrate 2 and the third substrate 4, and the gas chamber 51 is in communication with the through hole 21 of the second substrate 2 and the gas flow channels 41 of the third substrate 4. Consequently, the gas inhaled into the gas chamber 51 through the through hole 21 flows out upwardly from the gas flow channels 41, so as to complete the gas transportation.

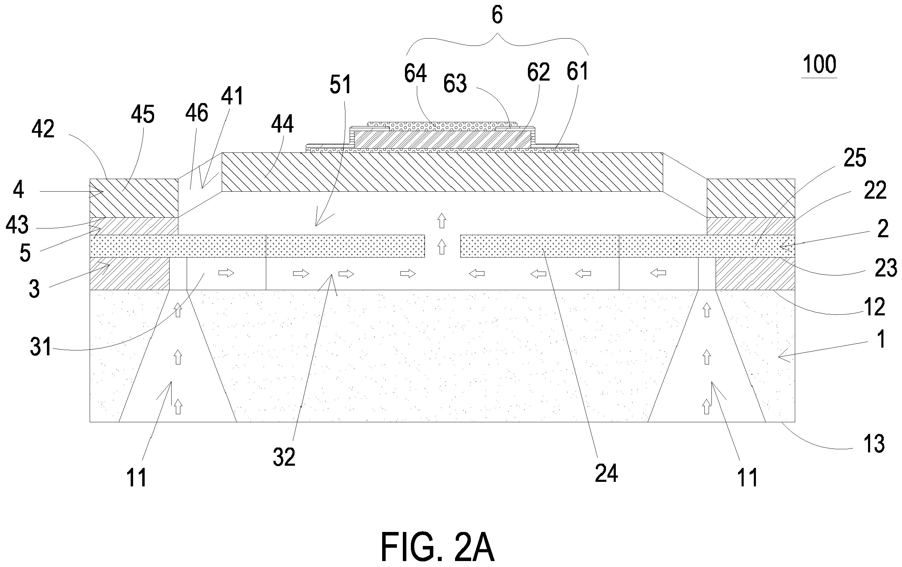

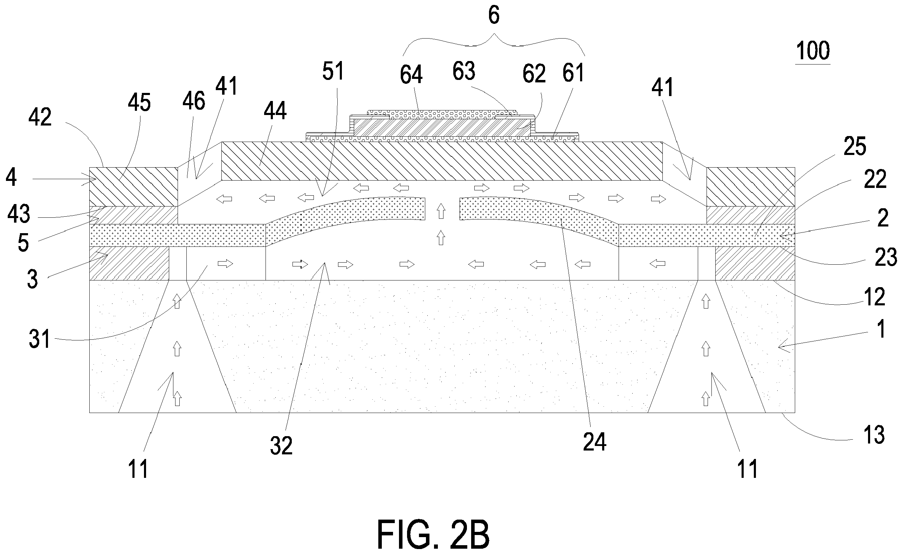

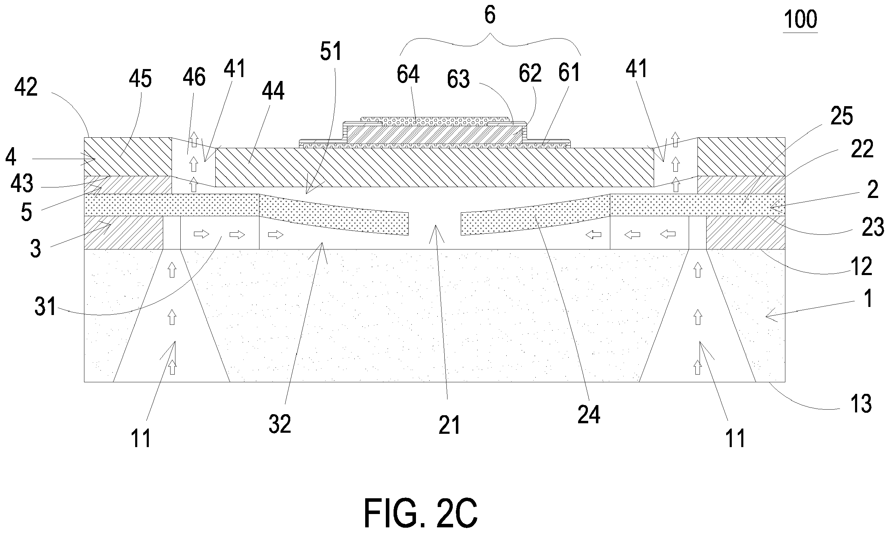

In order to clarify the operation steps of the MEMS pump 100 manufacturing by micro-manufacturing process of the semiconductor process, please refer to FIGS. 2A to 2C. Please refer to FIG. 2A first, when the lower electrode layer 61 and the upper electrode layer 64 of the piezoelectric element 6 receive the voltages and driving signals from the exterior and then transmit to the piezoelectric layer 62, the piezoelectric layer 62 is driven to deformation due to a piezoelectric effect. The variation and frequency of the deformation of the piezoelectric layer 62 are controlled by the voltages and driving signals. As the result of the deformation of the piezoelectric layer 62 described above, the vibration part 44 of the third substrate 4 is driven to displace upwardly away from the second oxide layer 5. As the distance from the vibration part 44 to the second oxide layer 5 is increased by the driving of the piezoelectric element 6, and the volume of the gas chamber 51 of the second oxide layer 5 is expanded, a negative pressure is generated inside the gas chamber 51, thereby the gas from an environment outside the MEMS pump 100 is inhaled into the inlet apertures 11, and then converged to the convergence chamber 32 of the first oxide layer 3. Then, as shown in FIG. 2B, as the vibration part 44 is drawn by the piezoelectric element 6 and vibrates upwardly, the resonance part 24 of the second substrate 2 resonates to vibrate upwardly, so as to compress the volume of the gas chamber 51 and push the gas in the gas chamber 51 toward the gas flow channels 41 of the third substrate 4, then the gas is exhausted upwardly through the gas flow channels 41. Meanwhile, as the resonance part 24 vibrates upwardly and compresses the gas chamber 51, the volume of the convergence chamber 32 is expanded accordingly, thereby generating a negative pressure in the convergence chamber 32, so as to allow the gas from the exterior of the MEMS pump 100 to be inhaled continuously through the inlet apertures 11. Finally, as shown in FIG. 2C, when the vibration part 44 of the third substrate 4 is driven to displace downwardly by the piezoelectric element 6, the resonance part 24 of the second substrate 2 is also driven to displace downwardly at the same time. Hence, the gas in the convergence chamber 32 is compressed and pushed to move toward the gas chamber 51 through the through hole 21, and the gas from the exterior of the MEMS pump 100 temporarily stops inhaling from the inlet apertures 11. At the same time, the gas in the gas chamber 51 is pushed toward the gas flow channels 41 of the third substrate 4, and exhausted outwardly. After that, the vibration part 44 is driven to displace upwardly by the piezoelectric element 6, and the volume of the gas chamber 51 is increased, so as to generate a higher suction force and suck the gas into the gas chamber 51 (as shown in FIG. 2A). By repeating the operation steps illustrated in FIGS. 2A to 2C continuously, the vibration part 44 is driven to displace upwardly and downwardly by the piezoelectric element 6, and thereby actuated the resonance part 24 to be displaced synchronously in resonance. As a result, the inner pressure of the MEMS pump 100 is continuously changed to inhale and exhaust gas continuous, so as to complete the gas transmission of the MEMS pump 100.

In summary, the present disclosure provides an MEMS pump. The structure of the MEMS pump is manufactured by a semiconductor process to decrease the volume of the MEMS pump, so as to achieve the object of reducing the volume of the MEMS pump, and makes the MEMS pump more compact and miniature, so as to solve the problem of excessive pump volume in the prior art

## Claims

1. A micro-electromechanical system (MEMS) pump (100), **characterized by** comprising:
a first substrate (1) manufactured by a semiconductor process and having a first thickness formed by a thinning process and at least one inlet aperture (11) formed by a lithography and etching process;
a first oxide layer (3) manufactured by the semiconductor process and having at least one fluid inlet channel (31) and a convergence chamber (32) formed by the lithography and etching process, wherein the first oxide layer (3) is stacked on the first substrate (1), one end of the at least one fluid inlet channel (31) is in communication with the convergence chamber (32), and the other end of the at least one fluid inlet channel (31) is in communication with the at least one inlet aperture (11);
a second substrate (2) manufactured by the semiconductor process and having a second thickness formed by the thinning process and a through hole (21) formed by the lithography and etching process, wherein the second substrate (2) is stacked on the first oxide layer (3), and the through hole (21) is misaligned with the inlet aperture (11) of the first substrate (1) and in communication with the convergence chamber (32) of the first oxide layer (3);
a second oxide layer (5) formed by a sputtering process and stacked on the second substrate (2), wherein the second oxide layer (5) has a gas chamber (51) with a concave central portion formed by the lithography and etching process;
a third substrate (4) manufactured by the semiconductor process and having a third thickness formed by the thinning process and a plurality of gas flow channels (41) formed by the lithography and etching process, wherein the third substrate (4) is stacked on the second oxide layer (5), the plurality of gas flow channels (41) are misaligned with the through hole (21) of the second substrate (2), and the gas chamber (51) of the second oxide layer (5) is in communication with the through hole (21) of the second substrate (2) and the plurality of gas flow channels (41) of the third substrate (4); and
a piezoelectric element (6) manufactured by the semiconductor process and stacked on the third substrate (4), wherein the first substrate (1), the first oxide layer (3), the second substrate (2), the second oxide layer (5), the third substrate (4) and the piezoelectric element (6) are fabricated into a modular structure, and the modular structure has a length (L), a width (W) and a height (H).

2. The MEMS pump (100) according to claim 1, wherein the modular structure has a volume with the length (L) ranging from 1 mm to 999 mm, the width (W) ranging from 1 mm to 999 mm and the height (H) ranging from 1 mm to 999 mm.

3. The MEMS pump (100) according to claim 1, wherein the modular structure has a volume with the length (L) ranging from 1 µm to 999 µm, the width (W) ranging from 1 µm to 999 µm and the height (H) ranging from 1 µm to 999 µm.

4. The MEMS pump (100) according to claim 1, wherein the modular structure has a volume with the length (L) ranging from 1 nm to 999 nm, the width (W) ranging from 1 nm to 999 nm and the height (H) ranging from 1 nm to 999 nm.

5. The MEMS pump (100) according to claim 1, wherein the first substrate (1), the second substrate (2) and the third substrate (4) are silicon chips formed by a crystal growth process of the semiconductor process.

6. The MEMS pump (100) according to claim 5, wherein the silicon chips are polysilicon chips.

7. The MEMS pump (100) according to claim 1, wherein the thinning process is selected from the group consisting of a grinding process, an etching process, a cutting process and a combination thereof.

8. The MEMS pump (100) according to claim 1, wherein the piezoelectric element (6) is formed by a film deposition process of the semiconductor process.

9. The MEMS pump (100) according to claim 8, wherein the film deposition process is a physical vapor deposition (PVD) process or a chemical vapor deposition (CVD) process.

10. The MEMS pump (100) according to claim 1, wherein the piezoelectric element (6) is formed by a sol-gel of the semiconductor process.

11. The MEMS pump according to claim 1, wherein the piezoelectric element (6) further comprises:
a lower electrode layer (61);
a piezoelectric layer (62) stacked on the lower electrode layer (61);
an insulation layer (63) covered on a partial surface of the piezoelectric layer (62) and a partial surface of the lower electrode layer (61); and
an upper electrode layer (64) stacked on the insulation layer (63) and a remaining surface of the piezoelectric layer (62) without the insulation layer (63) disposed thereon, so as to electrically connect with piezoelectric layer (62).

12. The MEMS pump (100) according to claim 1, wherein the inlet hole (11) of the first substrate (1) is cone-shaped.

13. The MEMS pump (100) according to claim 1, wherein the first thickness is greater than the third thickness, and the third thickness is greater than the second thickness.

14. The MEMS pump (100) according to claim 1, wherein the thickness of the first oxide layer is greater than the thickness of the second oxide layer.

15. A micro-electromechanical system (MEMS) pump (100), **characterized by** comprising:
a first substrate (1) manufactured by a semiconductor process and having a first thickness formed by a thinning process and at least one inlet aperture (11) formed by a lithography and etching process;
a first oxide layer (3) manufactured by the semiconductor process and having at least one fluid inlet channel (31) and a convergence chamber (32) formed by the lithography and etching process, wherein the first oxide layer (3) is stacked on the first substrate (1), one end of the at least one fluid inlet channel (31) is in communication with the convergence chamber (32), and the other end of the at least one fluid inlet channel (31) is in communication with the at least one inlet aperture (11);
a second substrate (2) manufactured by the semiconductor process and having a second thickness formed by the thinning process and a through hole (21) formed by the lithography and etching process, wherein the second substrate (2) is stacked on the first oxide layer (3), and the through hole (21) is misaligned with the inlet aperture (11) of the first substrate (1) and in communication with the convergence chamber (32) of the first oxide layer (3);
a second oxide layer (5) formed by a sputtering process and stacked on the second substrate (2), wherein the second oxide layer (5) has a gas chamber (51) with a concave central portion formed by the lithography and etching process;
a third substrate (4) manufactured by the semiconductor process and having a third thickness formed by the thinning process and a plurality of gas flow channels (41) formed by the lithography and etching process, wherein the third substrate (4) is stacked on the second oxide layer (5), the plurality of gas flow channels (41) are misaligned with the through hole (21) of the second substrate (2), and the gas chamber (51) of the second oxide layer (5) is in communication with the through hole (21) of the second substrate (2) and the plurality of gas flow channels (41) of the third substrate (4); and
a piezoelectric element (6) formed by the semiconductor process and stacked on the third substrate (4), wherein the first substrate (1), the first oxide layer (3), the second substrate (2), the second oxide layer (5), the third substrate (4) and the piezoelectric element (6) are fabricated into a modular structure, and the modular structure has a length (L) ranging from 1 nm to 999 nm, a width (W) ranging from 1 nm to 999 nm and a height (H) ranging from 1 nm to 999 nm.
